# EUROPEAN PATENT SPECIFICATION

(11) **EP 3 564 325 B1**
(45) Date of publication and mention of the grant of the patent: **04.11.2020**
(21) Application number: 18901800.5
(22) Date of filing: 27.12.2018
(51) Int. Cl.: C09D 7/62, C09C 3/12, C09C 1/36, C09D 201/00, H05K 9/00, C09D 5/24, C09D 5/32, C09D 7/61, C09D 7/40

(54) **COATING COMPOSITION, COATING FILM, AND COMPOSITE FOR SHIELDING ELECTROMAGNETIC WAVE**
BESCHICHTUNGSZUSAMMENSETZUNG, BESCHICHTUNGSFILM UND VERBUNDSTOFF ZUR ABSCHIRMUNG ELEKTROMAGNETISCHER WELLEN
COMPOSITION DE REVÊTEMENT, FILM DE REVÊTEMENT ET COMPOSITE POUR BLINDAGE CONTRE LES ONDES ÉLECTROMAGNÉTIQUES

(30) Priority: 25.01.2018 KR 20180009507
(43) Date of publication of application: 06.11.2019
(73) Proprietor: LG Chem, Ltd., Seoul 07336 (KR)
(72) Inventor: LEE, Joohyung, Daejeon 34122 (KR)
(74) Representative: Goddar, Heinz J.
(86) International application number: PCT/KR2018/016769
(87) International publication number: WO 2019/146921

(56) References cited:
- CN-A- 106 270 840
- KR-A- 20160 114 652
- KR-A- 20170 093 041
- KR-B1- 101 519 749
- KATHLEEN MALESKI ET AL: "Dispersions of Two-Dimensional Titanium Carbide MXene in Organic Solvents", CHEMISTRY OF MATERIALS, vol. 29, no. 4, 28 February 2017 (2017-02-28), pages 1632-1640, XP055659164, ISSN: 0897-4756, DOI: 10.1021/acs.chemmater.6b04830
- Shahzad, Faisal et al.: "Electromagnetic interference shielding with 2D transition metal carbides (MXenes)", Science, vol. 353, no. 6304, 9 September 2016 (2016-09-09), pages 1137-1140, XP055611682, DOI: 10.1126/science.aag2421
- Liu, Ji et al.: "Hydrophobic, Flexible, and Lightweight MXene Foams for High Performance Electromagnetic Interference Shielding", Advanced Materials, vol. 29, no. 38, 1702367, 11 August 2017 (2017-08-11), XP055611688, DOI: 10.1002/adma.201702367

## Description

### [TECHNICAL FIELD]

### Technical Field

The present disclosure relates to a use of a coating composition, a coating film and an EMI shielding composite. More particularly, the present disclosure relates to the use of a coating composition capable of providing a film which maintains high compatibility and dispersibility among the respective components and has low resistance, high electrical conductivity and excellent surface properties, a coating film having low resistance, high electrical conductivity and excellent surface properties, and a novel EMI shielding composite.

### [BACKGROUND OF ART]

MAX phase (wherein M is a transition metal, A is an element of Group 13 or 14, and X is carbon and/or nitrogen) is known as one of two-dimensional materials having a structure similar to graphene. It is also known that the MAX phase has excellent physical properties such as electrical conductivity, oxidation resistance and mechanical processability, and the like.

In recent years, a two-dimensional material called "MXene" has been introduced. This two-dimensional material with completely different properties was obtained by selectively removing aluminum layers using hydrofluoric acid in three-dimensional titanium-aluminum carbide of the MAX phase. The MXene has electrical conductivity and strength similar to those of graphene. Due to these properties, there are attempts to apply the MXene in various fields.

However, the MXene has a hydrophilic surface, and is well dispersed in water but not in hydrophobic organic solvents. Because of these characteristics, most of the previous researches have been carried out using water dispersion of MXene.

In order to apply MXene to various industrial fields, it is important to control dispersion of MXene in an organic solvent with low surface tension and high volatility. However, in the case of a material prepared by dispersing MXene itself in an organic solvent, sufficient electrical conductivity and EMI shielding effectiveness are difficult to secure, due to problems such as low wettability and dispersibility of the MXene surface to the organic solvent.

CN 106270840 A discloses MXene Ti₃C₂ surface-functionalized with an organosilane, and a composition comprising this compound in kerosene.

### [DETAILED DESCRIPTION OF THE INVENTION]

### [Technical Problem]

The present disclosure is to provide use of a coating composition capable of providing a film which maintains high compatibility and dispersibility among the respective components and has low resistance, high electrical conductivity and excellent surface properties.

The present disclosure is also to provide a coating film having low resistance, high electrical conductivity and excellent surface properties.

The present disclosure is also to provide an EMI shielding composite having low resistance, high electrical conductivity and excellent surface properties.

### [Technical Solution]

The present disclosure provides use of a coating composition including MXene surface-modified with an organosilane compound; and an organic solvent, for preparing a coating film or an EMI shielding composite.

The present disclosure also provides a coating film including MXene surface-modified with an organosilane compound.

The present disclosure also provides an EMI shielding composite including MXene surface-modified with an organosilane compound.

Hereinafter, the coating composition, the coating film and the EMI shielding composite will be described in more detail.

According to an embodiment of the present disclosure, provided is a coating composition including MXene surface-modified with an organosilane compound; and an organic solvent, for preparing a coating film or an EMI shielding composite.

The present inventors have conducted a study on a composite material using MXene, and have found through experiments that when the MXene surface having hydrophilicity is modified with an organosilane compound and mixed with an organic solvent, compatibility among the respective components may be enhanced, dispersibility of the surface modified MXene may become high, and products such as a finally produced film may have excellent surface properties with low resistance and high electric conductivity, thereby completing the present invention.

More specifically, in the MXene surface-modified with an organosilane compound, part of the surface or the entire surface may be hydrophobic. Therefore, it is highly compatible with organic solvents and can be evenly dispersed with other components that may be added to the coating composition such as polymeric resins or other additives.

The specific properties of the MXene surface-modified with an organosilane compound may vary depending on the specific use or characteristics of the coating composition of the above embodiment. For example, the content of the organosilane compound in the MXene surface-modified with an organosilane compound may vary.

However, in order for the final product prepared from the coating composition to achieve lower resistance and higher electrical conductivity, the organosilane compound may be included in the MXene surface-modified with an organosilane compound in an amount of 0.1 to 99.9 wt%, 0.5 to 30 wt%, or 1 to 10 wt%.

When the content of the organosilane compound in the MXene surface-modified with an organosilane compound is too high, electrical resistance may increase, which is technically unfavorable for application as a conductive material. When the content of the organosilane compound in the MXene surface-modified with an organosilane compound is too low, hydrophilicity of the MXene surface remains unchanged. Accordingly, when a film is formed by organic solvent-based dispersion, many defects may occur and the density may be decreased. As a result, it may be difficult to form a film having low electrical conductivity.

The MXene surface-modified with an organosilane compound may be formed by a sol-gel reaction between the organosilane compound and the MXene. Accordingly, in the MXene surface-modified with an organosilane compound, the organosilane compound and the MXene may be bonded via oxygen.

Meanwhile, the MXene may be represented by Ti₃C₂,

In addition, an element content ratio of silicon to 3 titanium (Si/Ti₃) in the MXene surface-modified with an organosilane compound is not particularly limited. However, in order for the final product prepared from the coating composition to achieve lower resistance and higher electrical conductivity, the element content ratio of silicon to 3 titanium (Si/Ti₂) in the MXene surface-modified with an organosilane compound may be 0.010 to 50, 0.020 to 45, or 0.030 to 40.

Examples of the organosilane compound modified on the MXene surface are not limited, but a silane compound having a non-ionic alkyl group or a phenyl group may be used in order to have minimum hydrophobicity.

Examples of the organosilane compound modified on the MXene surface include tetramethoxysilane, tetraethoxysilane, tetraisopropoxysilane, methyltrimethoxysilane, methyltriethoxysilane, methyltriisopropoxysilane, ethyltrimethoxysilane, ethyltriethoxysilane, ethyl triisopropoxysilane, propyltrimethoxysilane, propyltriethoxysilane, propyltriisopropoxysilane, butyltrimethoxysilane, butyltriethoxysilane, butyltriisopropoxysilane, hexyltrimethoxysilane, hexyltriethoxysilane, hexyltriisopropoxysilane, octyltrimethoxysilane, octyltriethoxysilane, octyltriisopropoxysilane, decyltrimethoxysilane, decyltriethoxysilane, decyltriisopropoxysilane, octadecyltrimethoxysilane, octadecyltriethoxysilane, octadecyltriisopropoxysilane, vinylchlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyldiethoxysilane, 3-glycidoxypropyltriethoxysilane, phenyltrimethoxysilane, phenyltriethoxysilane, p-aminophenyltrimethoxysilane, p-styryltrimethoxysilane, 3-(meth)acryloxypropyltriethoxysilane, 3-(meth)acryloxypropyltrimethoxysilane, 3-(meth)acryloxypropylmethyldimethoxysilane, 3-(meth)acryloxypropylmethyldiethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropylmethyldiethoxysilane, 3-aminopropyltrimethoxysilane, 3-aminopropyltriethoxysilane, 3-triethoxysilyl-N-(1,3-dimethylbutylidene)propylamine, N-phenyl-3-aminopropyltrimethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, 3-isocyanatepropyltriethoxysilane, 1H,1H,2H,2H-perfluorooctyltrimethoxysilane, 1H,1H,2H,2H-perfluorooctyltriethoxysilane, 1H,1H,2H,2H-perfluorooctyltrichlorosilane, and a mixture or a reaction product of two or more thereof.

Meanwhile, the coating composition may further include a polymeric binder, a precursor thereof or other additives.

Examples of the polymeric binder are not limited, and for example, at least one selected from the group consisting of an epoxy resin, polycarbonate (PC), polyvinyl chloride (PVC), polyethylene (PE), polypropylene (PP), polystyrene (PS), an acrylate-based resin, polyamide, an acrylonitrile-butadiene-styrene resin (ABS), polyamideimide (PAI), polybenzimidazole (PBI), polyether amide (PEI), polyphenylene sulfide (PPS), polytetrafluoroethylene (PTFE), polyvinylidene fluoride (PVDF), polyethylene terephthalate (PET), polyoxymethylene (POM), polyetheretherketone (PEEK), polyaryletherketone (PAEK), liquid crystal polymer (LCP), polyimide (PI), a (meth)acrylate-based polymer, a urethane (meth)acrylate-based polymer, and a polyurethane resin may be used.

As described above, the coating composition may include an organic solvent together with the MXene surface-modified with an organosilane compound.

The organic solvent may be included in an appropriate amount depending on the nature and use of the coating composition, for example, in the range of 10 to 98 wt% of the coating composition.

For example, the coating composition may include 80 wt% to 95 wt% of the organic solvent and 5 wt% to 20 wt% of MXene surface-modified with an organosilane compound.

The coating composition may be coated by a conventional coating method such as bar coating or spray coating, and may be provided as a coating film by removing the organic solvent after the coating.

The organic solvent is not limited as long as it is an organic compound capable of dispersing a polymeric binder or its precursor together with the MXene surface-modified with an organosilane compound. Specific examples of the organic solvent include, but are not limited to, ketones, alcohols, acetates and ethers, and a mixture of two or more thereof.

Examples of the organic solvent include ketones such as methyl ethyl ketone, methyl isobutyl ketone, acetyl acetone or isobutyl ketone; alcohols such as methanol, ethanol, diacetone alcohol, n-propanol, i-propanol, n-butanol, i-butanol or t-butanol; acetates such as ethyl acetate, i-propyl acetate, or polyethylene glycol monomethyl ether acetate; ethers such as tetrahydrofuran or propylene glycol monomethyl ether; and a mixture of two or more thereof.

According to another embodiment of the present disclosure, provided is a coating film including MXene surface-modified with an organosilane compound.

The coating film prepared from the coating composition including MXene surface-modified with an organosilane compound may have high density, and thus exhibit significantly improved electrical conductivity and low resistance. This is because the MXene surface-modified with an organosilane compound has excellent wettability to the organic solvent and disperses homogeneously in the organic solvent, thereby increasing the density of the film formed therefrom. That is, it is difficult to obtain the above characteristics by dispersing only the MXene itself in the organic solvent.

The thickness of the coating film is not particularly limited, and may be, for example, 0.1 *µ*m to 100 *µ*m, or 0.5 *µ*m to 50 *µ*m.

As described above, the coating film may have low resistance and high electrical conductivity. Specifically, the coating film may have sheet resistance of 100 Ω/square or less, 1 to 100 Ω/square, or 5 to 50 Ω/square, and electrical conductivity of 5,000 S/m or more, 5,000 S/m to 50,000 S/m, or 10,000 S/m to 30,000 S/m.

As described above, the MXene surface-modified with an organosilane compound has excellent wettability to the organic solvent and disperses homogeneously in the organic solvent. Accordingly, the surface of the film formed through the organic solvent dispersion of the MXene surface-modified with an organosilane compound may have few defects and high density.

In order for the coating film to achieve lower resistance and higher electrical conductivity, the organosilane compound may be included in the MXene surface-modified with an organosilane compound in an amount of 0.1 to 99.9 wt%, 0.5 to 30 wt%, or 1 to 10 wt%.

Meanwhile, the MXene may be represented by Ti₃C₂.

In addition, an element content ratio of silicon to 3 titanium (Si/Ti₃) in the MXene surface-modified with an organosilane compound is not particularly limited. However, in order for the coating film to achieve lower resistance and higher electrical conductivity, the element content ratio of silicon to 3 titanium (Si/Ti₃) in the MXene surface-modified with an organosilane compound may be 0.010 to 50, 0.020 to 45, or 0.030 to 40.

The coating film may further include a polymeric binder, a precursor thereof or other additives Examples of the polymeric binder include those described in the above coating composition.

According to another embodiment of the present disclosure, provided is an EMI shielding composite, including MXene surface-modified with an organosilane compound.

The EMI shielding composite may have characteristics of the coating composition and the coating film of the above-described embodiments.

The specific form of the EMI shielding composite is not limited, but may be a particle shape such as a film type, a spherical type, or the like.

### [ADVANTAGEOUS EFFECTS]

According to the present disclosure, provided are use of a coating composition capable of providing a film which maintains high compatibility and dispersibility among the respective components and has low resistance, high electrical conductivity and excellent surface properties, a coating film having low resistance, high electrical conductivity and excellent surface properties, and a novel EMI shielding composite.

### [BRIEF DESCRIPTION OF THE DRAWINGS]

FIG. 1 is a scanning electron microscope (SEM) image of the surface of the coating film prepared in Example 1.
FIG. 2 is a scanning electron microscope (SEM) image of the surface of the coating film prepared in Comparative Example 1.

### [DETAILED DESCRIPTION OF THE EMBODIMENTS]

Hereinafter, the present invention will be explained in detail with reference to the following examples. However, these examples are only to illustrate the invention, and the scope of the invention is not limited thereto.

### [Preparation Example: Preparation of MXene surface-modified with organosilane compound]

### Preparation Example 1

### (1) Preparation of MXene

Two-dimensional titanium carbide (Ti₃C₂) MXene, which is an etching product of Ti₃AlC₂ MAX phase, was used.

Specifically, the Ti₃AlC₂ MAX phase was prepared by mixing TiC, Al, and Ti at a weight ratio of 2: 1.2: 1.2, followed by calcining at 1425 °C for 15 minutes. Then, 20 g of the MAX phase was mixed with LiF and 6M HCl aqueous solution at a weight ratio of MAX phase: LiF: 6M HCI = 1: 1: 20, and stirred at 55 °C for 24 hours to prepare Ti₃C₂ MXene. Thereafter, the reaction product was purified through vacuum filtration using ethanol and water, and vacuum dried at room temperature to obtain final Ti₃C₂ MXene sample.

### (2) Surface modification of MXene

5 g of the prepared MXene was dispersed in 1 liter of water, and 55 g of an organosilane compound, propyltrimethoxysilane, was added thereto. The mixture was stirred at 50 °C for 16 hours to conduct a sol-gel dehydration condensation reaction. Through this process, MXene surface-modified with an organosilane compound was obtained. The remaining organosilane compound was then removed by centrifugation three times using ethanol as a rinse solution, and the surface-modified MXene was washed with the organosilane compound.

The content of silicon element introduced onto the MXene surface was confirmed by using Scanning Electron Microscopy and Energy Dispersive X-Ray (EDX) Analysis. The element content ratio of silicon to 3 titanium was 38.55 (Si/Ti₃= 38.55).

### Preparation Example 2

5 g of the MXene prepared in Preparation Example 1 was dispersed in 1 liter of a mixed solution of ethanol/water (volume ratio of 4/1), and 25 g of an organosilane compound, phenyltrimethoxysilane, was added thereto. The mixture was stirred at room temperature for 16 hours to conduct a sol-gel dehydration condensation reaction. Through this process, MXene surface-modified with an organosilane compound was obtained.

The remaining organosilane compound was then removed by centrifugation three times using methyl ethyl ketone as a rinse solution, and the surface-modified MXene was washed with the organosilane compound.

The content of silicon element introduced onto the MXene surface was confirmed in the same manner as in Preparation Example 1, and the element content ratio of silicon to 3 titanium was 0.033 (Si/Ti₃= 0.033).

### [Referential Example, Examples and Comparative Examples: Preparation of coating composition and coating film]

### Referential Example

0.4 g of the MXene (non-surface-modified) prepared in Preparation Example 1 was added to 4 ml of an organic solvent, methyl ethyl ketone, and then ball milling was performed for 1 hour using 12 g of 0.5 mm zirconium oxide (ZrO₂) beads and a paint shaker to prepare a coating composition (dispersion).

### Example 1

0.4 g of the MXene surface-modified with an organosilane compound prepared in Preparation Example 1 was added to 4 ml of an organic solvent, methyl ethyl ketone, and then ball milling was performed for 1 hour using 12 g of 0.5 mm zirconium oxide (ZrO₂) beads and a paint shaker to prepare a coating composition (dispersion).

The prepared dispersion was coated on a polyimide (Pl) film using HT-BC-ST (HanTech Co., Ltd.), and then thermally treated at 150 °C for 20 minutes to obtain a MXene film (thickness of 2.3 *µ*m).

### Example 2

A dispersion was prepared in the same manner as in Example 1, except that 0.8 g of the MXene surface-modified with an organosilane compound prepared in Preparation Example 2 was added to 8 ml of an organic solvent, methyl ethyl ketone, and then 24 g of 0.5 mm zirconium oxide (ZrO₂) beads were used.

The prepared dispersion was coated on a PI film using HT-BC-ST (HanTech Co., Ltd.), and then thermally treated at 150 °C for 20 minutes to obtain a MXene film (thickness of 2.3 *µ*m).

### Comparative Example 1

A dispersion and a MXene film (thickness of 2.4 *µ*m) were prepared in the same manner as in Example 1, except that 0.4 g of the MXene of Referential Example was used.

### Comparative Example 2

A MXene film (thickness of 2.4 *µ*m) was prepared in the same manner as in Example 2, except that 0.8 g of the MXene of Referential Example was used.

### [Experimental Examples]

### 1. Evaluation of dispersibility in organic solvents and colloidal stability

Each 2 mL of the coating composition (dispersion) obtained in Referential Example and Example 1 was taken and stored in a screw-type clear glass vial of 15 mm × 45 mm × 8 mm (outer diameter × height × inner diameter). Then, particle sizes of the upper and lower layers of the storage solution were measured over time (initial, after 1 day, after 3 days). In addition, a solid concentration remaining in the upper layer was measured over time (initial, after 1 day, after 3 days). Lastly, a solid weight ratio of a solid weight settled in the glass vial after 6 days to a total solid weight in the initial storage solution was measured. The particle size, the concentration of the upper layer of the storage solution and the final sedimentation amount were measured by the following methods.

### 1) Particle size

Each 5 *µ*ℓ of the upper and lower layer samples was taken over time (initial, after 1 day, after 3 days), and diluted to 4 mL of methyl ethyl ketone. The particle size of the diluted sample was measured by a dynamic light scattering method using Malvern Zetasizer Nano-ZS90 at a measuring angle of 90 °C, and the average particle size was calculated after repeating the measurement three times per sample.

### 2) Concentration of upper layer of storage solution

100 *µ*ℓ of the upper layer sample was taken over time (initial, after 1 day, after 3 days), and heated at 100 °C for 16 hours to completely evaporate the organic solvent. The remaining solid weight was measured using A&D Weighing Lab Balance GH-200, and the solid concentration remaining in the upper layer of the storage solution without sedimentation was calculated.

### 3) Final sedimentation amount

After 6 days, decantation was performed to remove all remaining storage solution from the glass vial, and the mixture was heated at 100 °C for 16 hours to completely evaporate the organic solvent. The remaining solid weight was measured using A&D Weighing Lab Balance GH-200, and expressed as the solid weight ratio of a solid weight settled in the glass vial to a total solid weight in the initial storage solution.

**[Table 1]**

| Sample | Sampling location | Particle size over time | | |
|---|---|---|---|---|
| | | Day 0 | Day 1 | Day 3 |
| Ex. 1 | Upper | 463.3 ± 6.46 nm | 454.03 ± 17.91 nm | 440 ± 15.31 nm |
| | Lower | | 596.03 ± 42.19 nm | 601.9 ± 26.63 nm |
| Rf. Ex. | Upper | 497.77 ± 11.11 nm | 162.17 ± 1.99 nm | 154.47 ± 1.12 nm |
| | Lower | | 463.53 ± 9.91 nm | 464.17 ± 6.54 nm |

**[Table 2]**

| Sample | Concentration of upper layer of storage solution over time | | |
|---|---|---|---|
| | Day 0 | Day 1 | Day 3 |
| Ex. 1 | 90.10 ± 2 mg/mL | 84.97 ± 2 mg/mL | 79.3 ± 2 mq/mL |
| Rf. Ex. | 93.87 ± 2 mg/mL | 1.90 ± 2 mg/mL | 1.63 ± 2 mg/mL |

**[Table 3]**

| Sample | Final sedimentation amount after Day 6 |
|---|---|
| Ex. 1 | 7.92 ±1.3 % |
| Rf. Ex. | 88.26 ± 3.0 % |

As shown in Tables 1 to 3, the coating composition (dispersion) obtained in Example 1 retained the particle sizes of the upper and lower layers relatively close to the initial values over time. On the other hand, in the coating composition (dispersion) obtained in Referential Example, the particle size of the upper layer became noticeably small, which is a result of sedimentation due to poor colloidal stability of relatively large MXene flakes. These results are also confirmed in the final sedimentation amount after 6 days of Table 3.

### 2. Evaluation of physical properties of coating film

Sheet resistance and electrical conductivity of the coating film prepared in Example 1 and Comparative Example 1 were measured as follows.
1) Thickness: It was measured using Tesa-µhite.
2) Sheet resistance: It was measured using Loresta-GX MCP-T700.
3) Electrical Conductivity: It was calculated using the measured sheet resistance and the thickness of the MXene film.

**[Table 4]**

| | Example 1 | Comparative Example 1 |
|---|---|---|
| Thickness | 2.3 µm | 2.4 µm |
| Sheet resistance | 21 Ω/ square | 440 Ω/ square |
| Electrical Conductivity | 20,704 S/m | 947 S/m |

As shown in Table 4, the coating film prepared in Example 1 had high electrical conductivity of about 22 times higher than that of the coating film of Comparative Example 1, and had low sheet resistance of about 1/20.

### 3. Evaluation of surface properties of MXene film

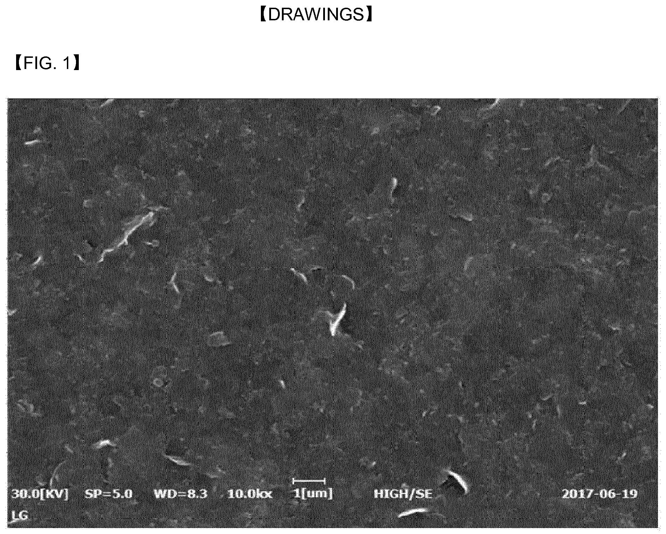

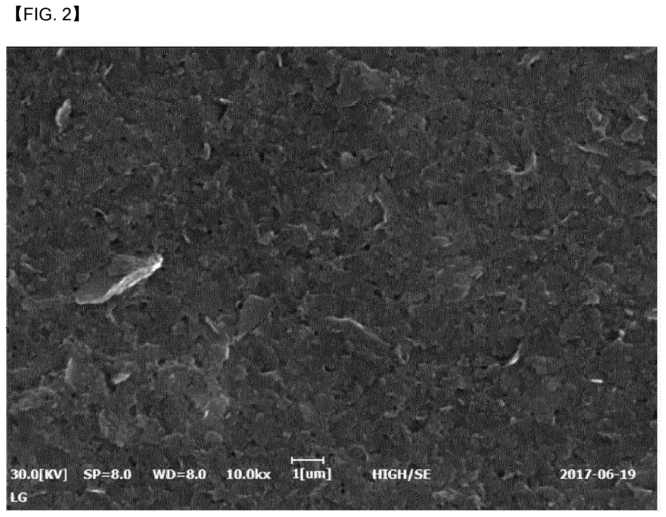

The surface properties of the MXene film prepared in Example 1 and Comparative Example 1 were confirmed by Scanning Electron Microscopy, and the results are shown in FIGs. 1 and 2.

Referring to FIGs. 1 and 2, it was confirmed that the surface of the coating film of Example 1 had a surface shape in which particles are connected more densely than the coating film of Comparative Example 1.

## Claims

1. Use of a coating composition, comprising MXene surface-modified with an organosilane compound; and an organic solvent for preparing a coating film or an EMI shielding composite.

2. The use of Claim 1,
wherein the MXene surface-modified with an organosilane compound has the organosilane compound in an amount of 0.5 to 30 wt%.

3. The use of Claim 1,
wherein the MXene surface-modified with an organosilane compound is formed by a sol-gel reaction between the organosilane compound and the MXene.

4. The use of Claim 1,
wherein the MXene is represented by Ti₃C₂, and
an element content ratio of silicon to 3 titanium (Si/Ti₃) in the MXene surface-modified with an organosilane compound is 0.010 to 50.

5. The use of Claim 1,
wherein the organosilane compound comprises at least one selected from the group consisting of tetramethoxysilane, tetraethoxysilane, tetraisopropoxysilane, methyltrimethoxysilane, methyltriethoxysilane, methyltriisopropoxysilane, ethyltrimethoxysilane, ethyltriethoxysilane, ethyl triisopropoxysilane, propyltrimethoxysilane, propyltriethoxysilane, propyltriisopropoxysilane, butyltrimethoxysilane, butyltriethoxysilane, butyltriisopropoxysilane, hexyltrimethoxysilane, hexyltriethoxysilane, hexyltriisopropoxysilane, octyltrimethoxysilane, octyltriethoxysilane, octyltriisopropoxysilane, decyltrimethoxysilane, decyltriethoxysilane, decyltriisopropoxysilane, octadecyltrimethoxysilane, octadecyltriethoxysilane, octadecyltriisopropoxysilane, vinylchlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyldiethoxysilane, 3-glycidoxypropyltriethoxysilane, phenyltrimethoxysilane, phenyltriethoxysilane, p-aminophenyltrimethoxysilane, p-styryltrimethoxysilane, 3-(meth)acryloxypropyltriethoxysilane, 3-(meth)acryloxypropyltrimethoxysilane, 3-(meth)acryloxypropylmethyldimethoxysilane, 3-(meth)acryloxypropylmethyldiethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropylmethyldiethoxysilane, 3-aminopropyltrimethoxysilane, 3-aminopropyltriethoxysilane, 3-triethoxysilyl-N-(1,3-dimethylbutylidene)propylamine, N-phenyl-3-aminopropyltrimethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, 3-isocyanatepropyltriethoxysilane, 1H,1H,2H,2H-perfluorooctyltrimethoxysilane, 1H,1H,2H,2H-perfluorooctyltriethoxysilane and 1H,1H,2H,2H-perfluorooctyltrichlorosilane.

6. The use of Claim 1,
further comprising a polymeric binder or a precursor thereof.

7. The use of Claim 6,
wherein the polymeric binder comprises at least one selected from the group consisting of an epoxy resin, polycarbonate (PC), polyvinyl chloride (PVC), polyethylene (PE), polypropylene (PP), polystyrene (PS), an acrylate-based resin, polyamide, an acrylonitrile-butadiene-styrene resin (ABS), polyamideimide (PAI), polybenzimidazole (PBI), polyether amide (PEI), polyphenylene sulfide (PPS), polytetrafluoroethylene (PTFE), polyvinylidene fluoride (PVDF), polyethylene terephthalate (PET), polyoxymethylene (POM), polyetheretherketone (PEEK), polyaryletherketone (PAEK), liquid crystal polymer (LCP), polyimide (PI), a (meth)acrylate-based polymer, a urethane (meth)acrylate-based polymer, and a polyurethane resin.

8. A coating film, comprising MXene surface-modified with an organosilane compound.

9. The coating film of Claim 8,
wherein the film has a thickness of 0.1 to 100*µ*m,
a sheet resistance of 100 Ω/square or less, and
an electrical conductivity of 5,000 S/m or more.

10. The coating film of Claim 8,
wherein the MXene surface-modified with an organosilane compound has the organosilane compound in an amount of 0.5 to 30 wt%.

11. The coating film of Claim 8,
wherein the MXene is represented by Ti₃C₂, and
an element content ratio of silicon to 3 titanium (Si/Ti₃) in the MXene surface-modified with an organosilane compound is 0.010 to 50.

12. The coating film of Claim 8,
further comprising a polymeric binder.

13. An EMI shielding composite, comprising MXene surface-modified with an organosilane compound.

## Patentansprüche

1. Verwendung einer Beschichtungszusammensetzung, die MXen, das mit einer Organosilanverbindung oberflächenmodifiziert ist; und ein anorganisches Lösungsmittel umfasst, zum Herstellen eines Beschichtungsfilms oder eines EMI -Abschirmungskomposits.

2. Verwendung nach Anspruch 1, wobei das MXen, das mit einer Organosilanverbindung oberflächenmodifiziert ist, die Organosilanverbindung in einer Menge von 0,5 bis 30 Gewichtsprozent aufweist.

3. Verwendung nach Anspruch 1, wobei das MXen, das mit einer Organosilanverbindung oberflächenmodifiziert ist, durch eine Sol-Gel-Reaktion zwischen der Organosilanverbindung und dem MXen gebildet ist.

4. Verwendung nach Anspruch 1, wobei das MXen durch Ti₃C₂ dargestellt ist, und
ein Elementgehaltsverhältnis von Silizium zu 3 Titan (Si/Ti₃) in dem MXen, das mit einer Organosilanverbindung oberflächenmodifiziert ist, 0,010 bis 50 ist.

5. Verwendung nach Anspruch 1, wobei die Organosilanverbindung wenigstens eine umfasst, die aus ausgewählt ist aus der Gruppe bestehend aus Tetramethoxysilan, Tetraethoxysilan, Tetraisopropoxysilan, Methyltrimethoxysilan, Methyltriethoxysilan, Methyltriisopropoxysilan, Ethyltrimethoxysilan, Ethyltriethoxysilan, Ethyltriisopropoxysilan, Propyltrimethoxysilan, Propyltriethoxysilan, Propyltriisopropoxysilan, Butyltrimethoxysilan, Butyltriethoxysilan, Butyltriisopropoxysilan, Hexyltrimethoxysilan, Hexyltriethoxysilan, Hexyltriisopropoxysilan, Octyltrimethoxysilan, Octyltriethoxysilan, Octyltriisopropoxysilan, Decyltrimethoxysilan, Decyltriethoxysilan, Decyltriisopropoxysilan, Octadecyltrimethoxysilan, Octadecyltriethoxysilan, Octadecyltriisopropoxysilan, Vinylchlorosilan, Vinyltrimethoxysilan, Vinyltriethoxysilan, 2-(3,4-Epoxycyclohexyl)ethyltrimethoxysilan, 3-Glycidoxypropyltrimethoxysilan, 3-Glycidoxypropylmethyldiethoxysilan, 3-Glycidoxypropyldiethoxysilan, 3-Glycidoxypropyltriethoxysilan, Phenyltrimethoxysilan, Phenyltriethoxysilan, p-Aminophenyltrimethoxysilan, p-Styryltrimethoxysilan, 3-(Meth)acryloxypropyltriethoxysilan, 3-(Meth)acryloxypropyltrimethoxysilan, 3- (Meth)acryloxypropylmethyldimethoxysilan, 3-(Meth)acryloxypropyl-methyldiethoxysilan, 3-Acryloxypropyltrimethoxysilan, N-2-(Aminoethyl)-3-aminopropylmethyldimethoxysilan, N-2-(Aminoethyl)-3-aminopropyl-trimethoxysilan, N-2-(Aminoethyl)-3-aminopropylmethyldiethoxysilan, 3-Aminopropyltrimethoxysilan, 3-Aminopropyltriethoxysilan, 3-Triethoxysilyl-N-(1,3-dimethylbutylidene)propylamin, N-Phenyl-3-aminopropyltrimethoxysilan, 3-Chloropropyltrimethoxysilan, 3-Mercaptopropylmethyldimethoxysilan, 3-Mercaptopropyltrimethoxysilan, Bis(triethoxysilylpropyl)tetrasulfid, 3-Isocyanatpropyltriethoxysilan, 1H,1H,2H,2H-Perfluorooctyltrimethoxysilan, 1H,1H,2H,2H-Perfluorooctyltriethoxysilan und 1H,1H,2H,2H-Perfluorooctyltrichlorosilan.

6. Verwendung nach Anspruch 1, weiter umfassend ein polymeres Bindemittel oder eine Vorstufe desselben.

7. Verwendung nach Anspruch 6, wobei das polymere Bindemittel wenigstens eines umfasst, das ausgewählt ist aus der Gruppe bestehend aus einem Epoxyharz, Polycarbonat (PC), Polyvinylchlorid (PVC), Polyethylen (PE), Polypropylen (PP), Polystyrol (PS), einem Harz auf Acrylatbasis, Polyamid, einem Acrylnitril-Butadien-Styrenharz (ABS), Polyamidimid (PAI), Polybenzimidazol (PBI), Polyetheramid (PEI), Polyphenylensulfid (PPS), Polytetrafluorethylen (PTFE), Polyvinylidenfluorid (PVDF), Polyethylenterephthalat (PET), Polyoxymethylen (POM), Polyethertherketon (PEEK), Polyaryletherketon (PAEK), flüssigem Kristallpolymer (LCP), Polyimid (PI), einem (Meth)acrylat-basierten Polymer, einem Urethan(meth)acrylatbasiertem Polymer und einem Polyurethanharz.

8. Beschichtungsfilm, umfassend MXen, das mit einer Organosilanverbindung oberflächenmodifiziert ist.

9. Beschichtungsfilm nach Anspruch 8, wobei der Film eine Dicke von 0,1 bis 100 µm,
einen Flächenwiderstand von 100 Ω/Quadrat oder weniger, und
eine elektrische Leitfähigkeit von 5.000 S/m oder höher aufweist.

10. Beschichtungsfilm nach Anspruch 8, wobei das MXen, das mit einer Organosilanverbindung oberflächenmodifiziert ist, die Organosilanverbindung in einer Menge von 0,5 bis 30 Gewichtsprozent aufweist.

11. Beschichtungsfilm nach Anspruch 8, wobei das MXen durch Ti₃C₂ dargestellt ist, und
ein Elementgehaltsverhältnis von Silizium zu 3 Titan (Si/Ti₃) in dem MXen, das mit einer Organosilanverbindung oberflächenmodifiziert ist, 0.010 bis 50 ist.

12. Beschichtungsfilm nach Anspruch 8, weiter umfassend ein polymeres Bindemittel.

13. EMI-Abschirmungskomposit, umfassend MXen, das mit einer Organosilanverbindung oberflächenmodifiziert ist.

## Revendications

1. Utilisation d'une composition de revêtement comprenant du MXène modifié en surface avec un composé organosilane ; et un solvant organique pour préparer un film de revêtement ou un composite de blindage contre les interférences électromagnétiques (IEM).

2. Utilisation selon la revendication 1,
dans laquelle le MXène modifié en surface avec un composé organosilane contient le composé organosilane en une quantité de 0,5 à 30 % en poids.

3. Utilisation selon la revendication 1,
dans laquelle le MXène modifié en surface avec un composé organosilane est formé par une réaction sol-gel entre le composé organosilane et le MXène.

4. Utilisation selon la revendication 1,
dans laquelle le MXène est représenté par le Ti₃C₂, et
un rapport entre la teneur en éléments du silicium et celle du titane 3 (Si/Ti₃) dans le MXène modifié en surface avec un composé organosilane est de 0,010 à 50.

5. Utilisation selon la revendication 1,
dans laquelle le composé organosilane comprend au moins un composé sélectionné dans le groupe constitué de tétraméthoxysilane, de tétraéthoxysilane, de tétraisopropoxysilane, de méthyltriméthoxysilane, de méthyltriéthoxysilane, de méthyltriisopropoxysilane, d'éthyltriméthoxysilane, d'éthyltriéthoxysilane, d'éthyl triisopropoxysilane, de propyltriméthoxysisilane, de propyltriéthoxysilane, de propyltriisopropoxysilane, de butyltriméthoxysilane, de butyltriéthoxysilane, de butyltriisopropoxysilane, d'hexyltriméthoxysilane, d'hexyltriéthoxysilane, d'hexyltriisopropoxysilane, d'octyltriméthoxysilane, d'octyltriéthoxysilane, d'octyltriisopropoxysilane, de décyltriméthoxysilane, de décyltriéthoxysilane, de décyltriisopropoxysilane, d'octadécyltriméthoxysilane, d'octadécyltriéthoxysilane, d'octadécyltriisopropoxysilane, de vinylchlorosilane, de vinyltriméthoxysilane, de vinyltriéthoxysilane, de 2-(3,4-époxycyclohexyl)éthyltriméthoxysilane, de 3-glycidoxypropyltriméthoxysilane, de 3-glycidoxypropylméthyldiéthoxysilane, de 3-glycidoxypropyldiéthoxysilane, de 3-glycidoxypropyltriéthoxysilane, de phényltriméthoxysilane, de phényltriéthoxysilane, de p-aminophényltriméthoxysilane, de p-styryltriméthoxysilane,de 3-(méth)acryloxypropyltriéthoxysilane, de 3-(méth)acryloxypropyltriméthoxysilane, de 3-(méth)acryloxypropylméthyldiméthoxysi!ane, de 3-(méth)acryloxypropylméthyldiéthoxysilane, de 3-acryloxypropyltriméthoxysilane, de N-2-{aminoéthyl)-3-aminopropylméthyldiméthoxysilane, de N-2-(aminoéthyl)-3-aminopropyltriméthoxysilane, de N-2-(aminoéthyl)-3-aminopropylméthyldiéthoxysilane, de 3-aminopropyltriméthoxysilane, de 3-aminopropyltriéthoxysilane, de 3-triéthoxysilyl-N-(1,3-diméthylbutylidène)propylamine, de N-phényl-3-aminopropyltriméthoxysilane, de 3-chloropropyltriméthoxysilane, de 3-mercaptopropylméthyldiméthoxysilane, de 3-mercaptopropyltriméthoxysilane, de bis(triéthoxysilylpropyl)tétrasulfure, de 3-isocyanatepropyltriéthoxysilane, de 1H, 1H,2H,2H-perfluorooctyltriméthoxysilane,de 1H,1H,2H,2H-perfluorooclyltriéthoxysilane et de 1H,1H,2H,2H-perfluorooctyltrichlorosilane.

6. Utilisation selon la revendication 1,
comprenant en outre un liant polymère ou un précurseur de celui-ci.

7. Utilisation selon la revendication 6,
dans laquelle le liant polymère comprend au moins un élément sélectionné dans le groupe constitué d'une résine époxy, d'un polycarbonate (PC), d'un chlorure de polyvinyle (PVC), d'un polyéthylène (PE), d'un polypropylène (PP), d'un polystyrène (PS), d'une résine à base d'acrylate, d'un polyamide, d'une résine acrylonitrile-butadiène-styrène (ABS), d'un polyamide-imide (PAI), d'un polybenzimidazole (PBI), d'un polyétheramide (PEI), d'un sulfure de polyphénylène (PPS), d'un polytétrafluoroéthylène (PTFE), d'un fluorure de polyvinylidène (PVDF), d'un polyéthylène téréphtalate (PET), d'un polyoxyméthylène (POM), d'un polyétheréthercétone (PEEK), d'un polyaryléthercétone (PAEK), d'un polymère à cristaux liquides (LCP), d'un polyimide (PI), d'un polymère à base de (méth)acrylate, d'un polymère à base d'uréthane (méth)acrylate et d'une résine de polyuréthane.

8. Film de revêtement, comprenant du MXène modifié en surface avec un composé organosilane.

9. Film de revêtement selon la revendication 8,
le film ayant une épaisseur de 0,1 à 100/*µ*m, une résistance en feuille de 100 Q/carré ou inférieure et une conductivité électrique de 5.000 S/m ou supérieure.

10. Film de revêtement selon la revendication 8,
dans lequel le MXène modifié en surface avec un composé organosilane contient le composé organosilane en une quantité de 0,5 à 30 % en poids.

11. Film de revêtement selon la revendication 8,
dans lequel le MXène est représenté par Ti₃C₂, et
le rapport entre la teneur en éléments du silicium et celle du titane 3 (Si/Ti₃) dans le MXène modifié en surface par un composé organosilane est de 0,010 à 50.

12. Film de revêtement selon la revendication 8, comprenant en outre un liant polymère.

13. Composite de blindage contre les IEM comprenant du MXène modifié en surface avec un composé organosilane.
